(19) Europäisches Patentamt
European Patent Office
Office européen des brevets

(11) EP 3 132 477 B1

(12) # EUROPEAN PATENT SPECIFICATION

(45) Date of publication and mention of the grant of the patent:
**14.08.2019 Bulletin 2019/33**

(21) Application number: **15710719.4**

(22) Date of filing: **19.03.2015**

(51) Int Cl.:
***H01L 51/52*** (2006.01)

(86) International application number:
**PCT/EP2015/000602**

(87) International publication number:
**WO 2015/158410 (22.10.2015 Gazette 2015/42)**

(54) **OLED DEVICE WITH THIN POROUS LAYERS OF MIXED METAL OXIDES**

OLED VORRICHTUNG MIT DÜNNEN PORÖSEN SCHICHTEN AUS GEMISCHTEN METALLOXIDEN

DISPOSITIF ÉLECTROLUMINESCENT ORGANIQUE (DELO) COMPORTANT DE MINCES COUCHES POREUSES D'OXYDES MÉTALLIQUES MIXTES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.04.2014 EP 14001390**

(43) Date of publication of application:
**22.02.2017 Bulletin 2017/08**

(73) Proprietor: **Merck Patent GmbH**
**64293 Darmstadt (DE)**

(72) Inventors:
- **BONRAD, Klaus**
  **64665 Alsbach-Haehnlein (DE)**
- **VOGES, Frank**
  **67098 Bad Duerkheim (DE)**
- **HAEMING, Marc**
  **74861 Neudenau (DE)**
- **KLYSZCZ, Andreas**
  **64291 Darmstadt (DE)**
- **HAYER, Anna**
  **64293 Darmstadt (DE)**

(56) References cited:
**WO-A1-2012/141875 US-A1- 2011 094 577**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 132 477 B1

## Description

The present invention relates to OLEDs (Organic Light Emitting Devices) with increased light outcoupling, to an improved process for the production of light outcoupling layers, and to the use thereof.

### State of the Art

OLEDs have undergone rapid development in recent years. They are increasingly replacing the liquid-crystal displays (LCDs) currently employed. Compared with LCDs, OLEDs have a number of advantages: they are distinguished firstly by a simpler structure and by lower energy consumption. In addition, they have reduced viewing-angle dependence.

The OLEDs currently available have the disadvantage of their excessively short lifetimes, which are necessary, in particular, for long-lived applications, such as, for example, backlighting of LCDs and general lighting.

However, intensive research is currently being carried out on this problem, on the one hand through the development of novel light-emitting materials having higher stability, but on the other hand also through improvement of the encapsulation of OLEDs. Both result in an increase in the lifetime of OLEDs.

A further approach to increasing the lifetime consists in increasing the efficiency of OLEDs, for example by increasing the light outcoupling of the OLEDs. In this way, it is possible to reduce the power consumption of OLEDs (and thus to save energy) for a constant light output or to increase light outcoupling for the same electrical power.

Whenever OLEDs are built in a standard substrate emitting architecture, the outcoupling efficiency is approximately 20%. The remaining 80% of the photons are trapped in organic and substrate modes in equal amounts. Hence, the greatest potential for a substantial increase in EQE (external quantum efficiency) and power efficiency is to enhance the light outcoupling [Reineke, S.; Lindner, F.; Schwartz, G.; Seidler, N.; Walzer, K.; Lüssem, B.; Leo, K.; Nature 2009 (459), 234-238]. It is generally known that about 40% of the light generated in the emitter layer is already lost in the internal layer systems, i.e. only 60% of the light generated is able to leave the internal layer system at all (so-called "internal outcoupling"). Likewise, about 40% of the light generated is lost at the substrate/air interface owing to total reflection, meaning that only about 20 to a maximum of 30% of all the light generated exits the OLED at all (so-called "external outcoupling"). The present invention relates to a changed OLED structure decreasing the loss of generated light in the internal layer systems, and to improve the internal outcoupling.

Fig. 1 shows the internal and external outcoupling of a conventional OLED diagrammatically.

There are various approaches for increasing the outcoupling efficiency and Nowy et al. [Nowy, S.; Frischeisen, J.; Brütting, W.; Organic Light Emitting Materials and Devices XIII, ed. By Franky So, Proc. of SPIE Vol 7415, 7415C1-8] have shown that layer thickness, material properties of the different layers joined together but also the dipole orientations of the light emitting layer have a significant influence on the total amount of emitted light from an OLED.

Various approaches to improve external light outcoupling are mentioned in WO 2007/076913 A1. This application discloses for this purpose a transparent layer which contains transparent, preferably spherical particles, which protrude at least partially out of the at least one layer which is arranged on the substrate and/or on the transparent 2nd electrode.

However, as important as the external outcoupling is the internal outcoupling of the various internal layers of which an OLED is construed. The internal outcoupling of generated light is one of the main factors in how much of the generated light leaves an OLED. Depending on the nature and thickness of the layers the generated light is transported in the layer medium and reflected at the interface or passes this. Accordingly, due to the different layer materials and thicknesses of OLEDs, the internal light outcoupling is of great importance in terms of effectiveness. Therefore, a number of scientific studies are dealing with the question of how the internal outcoupling can be optimized and several solutions were proposed.

As indicated above Nowy et al. [Nowy, S.; Frischeisen, J.; Brütting, W.; "Simulation based optimization of light-outcoupling in organic light-emitting diodes", In: Organic Light Emitting Materials and Devices XIII, ed. By Franky So, Proc. of SPIE Vol. 7415, 7415C1-8 (2009)] investigated the influence of layer thickness and its influence on device optimization. They found that the optimal layer thickness for best device performance is dependent on the quantum efficiency of the emitter material and must be considered in connection with the overall construction of the OLED.

Lee et al. [Lee, Y.; Se-Heon Kim, S.; Guk-Hyun Kim, G.; Lee, Y,; OPTICS EXPRESS (2005), Vol. 13, No. 15, 5864 - 5870] analyzed the behavior of thin $Si_xN_y$ layers deposited between the glass layer and the ITO layer, but which was nano patterned. Other researchers and developers analysed different layers of OLEDs for their internal outcoupling behaviour. Their researches are mainly focused on the following priorities:

1. The shape of the ITO electrode (patterned ITO).
2. Evaporation processed organic scattering layers, as suggested by Novaled in both bottom- and top-emission OLEDs
3. The shape of different layer building the device, which may form buckles as disclosed by Koo et al. (Nature

Photonics, Vol. 4, 2010 , 222- 226)
4. Scattering layer underneath an ITO layer positioned between this layer the glass substrate [Chang et al.; Journal of Appl. Phys. 113, 204502 (2013)]

All these studies have in common, that the internal light outcoupling is significantly influenced by the nature of each light-guiding layer and the transition from one layer to the other. As described above, it has been attempted to optimize these properties by different approaches, so that a higher luminous efficiency can be obtained. But all proposed solutions proposed so far comprise depositions of layers that consist of either special compositions or that must be applied in a more or less complex and expensive process whereby it must be ensured that already produced structures are not damaged.

In many processes for the production of electronic devices thin transparent films in the form of mixed metal oxides are produced. In this context mixed metal oxides are of high interest, which are processable from solution and which are printable. On the other hand environmental robustness of these films and transparency are desirable properties if they are applied on the outer surface. In this context, in various scientific articles thin transparent metal oxide layers have been described with smooth, dense surfaces.

Various scientific articles about thin transparent films made of mixed metal oxides show their diverse applicability depending on their structure and possibly depending on their morphological structure, but also depending on their physical optical properties. Therefore, synthesis and the production of precursors for mixed metal oxides have been studied extensively in the recent past because such layers are used for classical optics applications, such as for glasses or other optical glasses, but also in electronic components such as diodes (LEDs (OLEDs) and transistors, and the like.

In a variety of electronic devices an optimum light outcoupling in the visible range plays important role, both in the case of light entering and in the case of light emitted from the light device. These devices include solar cells (organic and inorganic), organic and polymeric light-emitting diodes (OLEDs and PLEDs), optical amplifiers, optical detectors, optical sensors, laser diodes, field-quench device, display, and display devices. Usually, these devices show a layered structure of different materials, including thin oxide layers, which the light has to pass through with the least possible loss of intensity.

In addition to optical properties, some of the applied metal oxides show electrically conductive or semi-conductive properties so that they can serve as conductor or semiconductor in electronic devices simultaneously.

In the past, oxide layers like ITO, ZnO, IZO, ITZO or IGZO layers were typically prepared by techniques such as sputtering or chemical or physical vapor deposition (CVD - chemical vapor deposition, PVD - Physical Vapor Deposition). These methods are well controlled so that the desired characteristics in terms of optical and physical properties can be well controlled. However, these procedures need complicated apparatus and cannot be carried out at atmospheric conditions.

In addition, this metal oxide can also be obtained by acid-or base-catalyzed sol-gel processes. However, these methods have the disadvantage that the sols used usually have only an extremely short lifetime while maintaining quality and constantly changing gradually during storage, so that a large-scale industrial production is difficult to control.

All these methods have in common that larger variations in the composition of the layers obtained are not possible. However, the material composition and structure of the layer determine the optical behavior.

In addition, WO 2012/141875 discloses an OLED device with a porous metal oxide outcoupling layer between the bottom electrode and the substrate. US 2011/094577 discloses an OLED device with a porous metal oxide electrode to enhance light outcoupling.

## Object of the invention

As described, it has been found by scientific studies, that only 20% of the generated light can exit the multilayer stack in an OLED (organic light-emitting diode) due to absorption or reflection at the interfaces within the device which reduce the internal and the external light outcoupling. For an increased external light outcoupling, arrays of micro lenses or diffusers are brought on top of the cover glass. But a large loss of light produced from the emitting layer occurs already in the inner layers and at the interfaces of OLEDs. Thus it is an object of the present invention to improve the amount of emitted light from OLED elements and especially to improve the internal light outcoupling from the inner surface properties of such OLED devices at the same time.

Furthermore, it is also an object of the present invention to provide inexpensive means and a simple feasible process for the inclusion of this agent in OLED structures, so that the internal light outcoupling can be improved already in stack layers of OLEDs. A further object of the present invention is to provide such a method of disposal that is feasible without having adverse effects on sensitive organic emitter layers.

Summary of the invention

The present invention provides a new OLED device according to claim 1. The new device shows at least one additional thin, porous and transparent mixed metal oxide layer comprising mixed oxides of at least two metals selected from the group of indium, zinc, tin, aluminum, gallium, cadmium, titanium and niobium with the proviso that the mixed oxide comprises indium oxide. A measurable improved internal light outcoupling can be shown in devices comprising at least one additional thin porous and transparent mixed metal oxide layer containing indium zinc oxide. For the improved light outcoupling additional thin porous and transparent mixed metal oxide layer are inserted having a thickness in the range of 10 - 200 nm, preferably in the range of 20 - 50 nm, preferably a thickness in the range of 20 - 40 nm.
The present invention is especially directed to OLED devices showing at least one additional thin, porous and transparent metal oxide layer for an improved light outcoupling.
Furthermore the present invention is directed to a process for manufacturing such devices with improved internal light outcoupling characterized in that at least one additional thin porous and transparent intermediate layer is inserted into the layered structure by the steps of

a) applying a precursor composition comprising at least two metal oxide precursors and optionally a suitable porogen or blowing agent, which is applied to a respective intermediate layer
b) drying the applied layer
and
c) converting the dried layer into the corresponding thin porous and transparent mixed metal oxide layer by rapid heating.

In a special embodiment the process according to the present invention is carried out in that the porous intermediate layer is inserted by applying and conversion of a single precursor composition layer. However, particularly good results are obtained, if the porous intermediate layer is inserted by applying and conversion precursor composition layers repeatedly. The process of the present invention is carried out in that the intermediate layer is produced by applying a solution having a metal oxide precursor concentration in the range of 1 - 20 % by weight, preferably in the range of 9 - 15% by weight and in that the conversion of the precursor composition into mixed oxide(s) is carried out by rapid heating to temperatures >150 °C to 500°C, preferably to temperatures in the range of 300 - 450°C. The rapid heating to conversion temperature and keeping the temperature is carried out for at least 30 seconds up to 4 minutes.

Detailed description of the invention

As such, an extra layer on a structured ITO layer in a layer stack of an OLED may be acceptable on condition that it is compatible with further cleaning steps and that it doesn't lead to a loss in device performance.
As is known from solar cell technology, certain metal oxides or mixed oxides or doped metal oxides, when they are applied in thin layers to a substrate, show high transmittance values for visible light (in the wavelength range of 380 to 780 nm) combined with a high reflectance in the IR region.
This applies in particular to transparent aluminum-doped tin oxide layers (AZO) or indium tin oxide layers (ITO). Here, the high transmittance is related to the morphological structure of the layers, which is obtained by thermal treatment (sintering) at high temperatures.
While it is possible in the solar cell technology to improve the light transmittance in flexible solar cells by incorporating corresponding functional metal oxide particles in the organic support matrix, such particles could be disturbing in the light-emitting organic layer in view of their influence on the luminous efficiency.
However, in order to investigate the suitability of thin transparent metal oxide layers to improve the internal light outcoupling known precursors were deposited under different conditions and in different composite formulations on appropriate carriers and thermally treated. Then the quality of the obtained thin oxide films has been studied and evaluated with regard to the behavior of their light-conducting, light outcoupling and transmission properties. As a result of these studies it has been found, that special mixed metal oxide layers may fulfill the needed requirements for an improved internal light outcoupling.
To investigate the possibilities of corresponding precursors, they were dissolved in different solvents and processed in different ways to formulations which can be applied by spin coating, ink-jet-printing, gravure printing or flexographic printing as thin homogeneous films on surfaces to be treated. After drying these films are treated in an annealing process at elevated temperatures >230°C, preferably in the range of about 300 - 450 °C for a short time whereby the precursors are converted into the corresponding metal oxides or mixed metal oxides.
However, the conversion may also be effected by exposure to actinic radiation, that is by means of UV- and/or IR radiation. UV irradiation is carried out at wavelengths <400 nm, preferably in the range of 150 to 380 nm. IR radiation can be carried out at wavelengths of >800 nm, preferably of >800 to 3000 nm. Also by this irradiation, organometallic

precursors decompose and give volatile organic components, and optionally water, so that a metal oxide or mixed metal oxide layer remains on the substrate.

Surprisingly, these experiments have shown that certain metal oxides or mixed oxides or doped metal oxides can improve the light transmittance between the different layers, when they are applied in thin layers between special layers in an OLED structure. If such metal oxide layers are deposited between the glass substrate and the transparent ITO electrode a slightly improved light outcoupling can be effected in the wavelength range of visible light. This effect occurs especially when the applied thin transparent metal oxide layers are uniform and homogeneous and have a highly porous structure. Such transparent porous layers have proven to be particularly effective in this context, when they are inserted between the ITO electrode and the HT layer (HTL = hole transport layer).

Depending on between which layers such transparent porous metal oxide layers are inserted, an improvement of the light outcoupling can be achieved. While the insertion of such porous layers between the glass substrate and the transparent ITO electrode only leads to an increased efficiency of light outcoupling by a few percent, the insertion between the ITO electrode and the HT layer can be in the range of more than 20 %. This improvement is achievable, when the thicknesses of the additionally inserted porous layer(s), the hole transport layer, and ITO layer are adjusted to one another in a suitable ratio. Another parameter of the additional layer to be set is in the light refractive index, which should be set in a range such that the influence of the inserted additional porous mixed oxide layer and the adjacent layers is kept as small as possible. As the refractive index (n20/D) of ITO is about 1.5290-1.5460 the refractive index of this layer should be very similar, preferably in the range of about 1,35 and about 1,8. But the desirable value also depends on the position where the film is inserted and how thick it is. This means, that the refractive index of the inserted additional porous mixed oxide layer should be very similar to the neighboring layers and there should be very small steps between the refractive index values.

According to the present invention it seems be most effective to insert additional thin porous metal oxide layers with matched refractive index between the ITO and the HTL such that a composite device with a graded refractive index is obtained and which shows an improved efficiency because of an improved light outcoupling between the different layers.

The refractive index of the thin layers can be measured by various methods, for example by ellipsometry (R. M. A. Azzam, N. M. Bashara, "Ellipsometry and Polarised Light", North Holland Physics, 1987), by means of a prism coupler or by surface plasmone resonance spectroscopy.

The thickness of the inserted transparent, porous layer for optimum light outcoupling, in turn, also depends on the thickness of the other layers of the OLED. This means, the effectiveness of light outcoupling is significantly influenced by the total thickness, which is built up by the thickness of electron transport layer, emitting layer, hole transport layer, and ITO layer. Depending of the chemical nature of the inserted transparent porous metal oxide layer it can be in the range of 70 up to 200 nm, but it may be substantially thinner, for example in the range of 15 to 50 nm. The required thickness depends on the overall construction or the OLED structure, and wherein a maximum of light outcoupling can be achieved. If, for example a porous indium zinc oxide layer (IZO layer) is inserted between the hole transport layer and the ITO electrode the optimum thickness of the inserted IZO layer is about 88 nm while the optimum thickness of the hole transport layer (prepared of livilux® HTM-081) is about 123 nm. This means, that if a transparent, porous metal oxide layer is inserted in order to improve the effecvity of light outcoupling behavior of the OLED structure the other layers have to be made thinner. Therefore, the overall structure of the OLED should be simulated in advance.

Structure of an inventive OLED

The present invention thus relates to an OLED which has at least

- one substrate, preferably of glass or a flexible polymer,
- a 1st electrode,
- at least one organic light-emitting layer, and
- a 2nd electrode,
  where at least either
- the substrate and the 1st electrode,
- the 2nd electrode or
- the substrate and the 1st and 2nd electrodes are transparent, which is characterised in that at least one porous transparent metal oxide layer, is arranged between the ITO and the HTL and/or the transparent 2nd electrode, preferably between the transparent with the proviso that the function of the electrode is not affected by the additional transparent porous oxide layer.

This means, in a first preferred embodiments ("bottom emission" OLED), the OLED has the following structure:

- a transparent substrate, preferably of glass or a flexible polymer,

- a transparent 1st electrode,
- at least one organic light-emitting layer, and
- a 2nd electrode,

which is characterised in that at least one transparent porous metal oxide layer is arranged between the ITO and the HTL.

In a further embodiment ("transparent" OLED), the OLED has the following structure:

- a transparent substrate, preferably of glass or a flexible polymer,
- a transparent 1st electrode,
- at least one organic light-emitting layer, and
- a transparent 2nd electrode,

which is characterised in that at least one transparent porous metal oxide layer, is arranged between the ITO and the HTL. In this embodiment, at least one transparent porous metal oxide layer, is particularly preferably arranged on both the transparent substrate and on at least on the ITO, such that the internal light outcoupling between the different layers is improved.

In the above-mentioned embodiments, either the 1st electrode can be designed as the anode and the 2nd electrode as the cathode, or vice versa, where the first-mentioned alternative represents the preferred embodiment.

The additionally inserted porous transparent oxide layer according to the invention must meet essentially two requirements. It must have a porous structure and must have a requisite transparency. Preferably these layers should be prepared from commercially available, inexpensive starting materials in a simple way, such as, for example, from precursor compositions for glass or glass-like layers which can be applied in form of solutions that are low viscous, but which may also have higher viscosities depending on the type of application to the surface. Preferably precursor solutions are applied having viscosities in the range of liquids, this means in the range of 0,8 - 20 mPas.

The above-mentioned porous transparent oxide layer can be prepared in an optimised type of application, for example by spin coating, screen printing or flexographic printing of an adapted composition which subsequently is converted to the desired porous oxide layer.

The additionally inserted porous transparent oxide layer(s) can either cover the entire surface or be structured. This depends on the special structure of the OLED.

Furthermore, the material for the at least one porous transparent oxide layer may also be coloured. The provision of materials for colouring the at least one porous transparent oxide layer is known to the person skilled in the art and which may be achieved by a suitable mixture precursor components of different metal oxides. In this way, it is possible to obtain a coloured outcoupling layer.

For the purposes of the present invention, the expression "transparent" means that the material has a light transmission of > 60 to 100% at least in part-regions of visible light, but preferably over the entire region. Preferably it means, that the material has a light transmission of > 90 to 100% at least in part-regions of visible light. More preferable it means, that the material has a light transmission of > 90 to 100% over the entire region.

Surprisingly, it has been found that it is possible significantly to increase the internal outcoupling of the OLEDs by means of the arrangement according to the invention of the at least one porous transparent oxide layer which is inserted into the OLED layer structure between the ITO and the HTL and which is suitable to improve the light outcoupling and transmission from one layer to the following layer.

Substrates which can be employed are all materials which are suitable for this purpose. Preferred substrate materials are, however, glass and plastics, where glass is particularly preferred. The glass employed can be all possible types of glass, such as, for example, typical window glass. However, preference is given to the use of flat glasses, as used in the display industry (for example soda-lime glass or alkali-free glass). Plastics which can be employed are all thermoplastics, but preferably polymers, such as, for example, polycarbonate (PC), polymethyl methacrylate (PMMA), poly-vinylcarbazole (PVK), polybutadienes, polyethylene (PE), polyethylene terephthalate (PET) and polyester. The thickness of the substrate is not restricted here, but is preferably in the range from 0.05 to 3 mm, particularly preferably in the range from 0.2 to 1.1 mm.

For the purposes of this invention, a transparent cathode or anode is taken to mean a cathode or anode which is transparent in the region of the incident or emitted light, preferably in the range from 400 to 800 nm. In some device structures (light-emitting electrochemical cell), unipolar electrodes may also be used.

The electrodes are generally selected in such a way that their potential matches the potential of the adjacent organic layer as well as possible in order to ensure the most efficient electron or hole injection possible.

The materials employed for the non-transparent or semitransparent cathode are preferably metallic materials, such as, for example, Al, Ag, Au or Cr. In one particularly preferred embodiment, two-layer systems (bilayer) comprising a thin layer of Ba, Li, LiF, Ca or Mg and a layer of a metal are vapour-deposited. Preferred as cathode are metals having a low work function, metal alloys or multilayered structures with various metals, such as, for example, alkaline earth

metals, alkali metals, main-group metals or lanthanides (for example Ca, Ba, Mg, Al, In, Mg, Yb, Sm, etc.). In the case of multilayered structures, further metals which have a relatively high work function, such as, for example, Ag, may also additionally be used, in which case combinations of the metals, such as, for example, Ca/Ag or Ba/Ag, are generally used. The materials employed for transparent or semitransparent cathodes, for example for "top emission" OLEDs or transparent OLEDs, are preferably transparent or semitransparent cathode materials, such as, for example, ITO.

The cathodes or cathode combinations usually have a thickness of between 10 and 10,000 nm, preferably between 20 and 1000 nm.

Something similar applies to other electrodes in electronic devices with light extraction, such as solar cells, flat panel systems, touch-sensitive screens or similar devices.

It may also be preferred to introduce a thin interlayer of a material having a high dielectric constant between a metallic cathode and the organic semiconductor (or other functional layers optionally present). Suitable for this purpose are, for example, alkali metal or alkaline earth metal fluorides, but also the corresponding oxides (for example LiF, $Li_2O$, $BaF_2$, MgO, NaF, etc.). The layer thickness of this dielectric layer is preferably between 0.1 and 10 nm.

The material employed for the transparent anode is indium tin oxide (ITO); this usually has a refractive index $n_{ITO}$ in the range of at least 1,5 - 2,0.

The light-emitting layers in OLEDs are in the layer structure embedded organic semiconductor layers, which preferably consist of organic molecules and which due to their structure facilitate singlet and / or triplet light emitting electron transitions. These layers layer can have either so-called "small molecules" or polymers, preferably conjugated polymers, as light-emitting materials. As such, the semiconducting materials which can be employed here are all materials which are known and suitable to the person skilled in the art for this purpose. From the literature, a large number of conjugated aromatic molecule systems and conjugated aromatic metal complexes with semiconductor properties is known, which have been studied for their suitability as light emitters [Lo, S.-C.; Burn, P. L.; Chem. Rev. 107, 1097 (2007); Williams, J. A. G.; Develary, S.; Rochester, D. L.; Murphy, L.; Coordin. Chem. Rev. 252, 2596 (2008)].

By an organic material in the context of this invention are not only purely organic compounds but also organometallic compounds and metal coordination compounds with organic ligands. As indicated above, this oligomeric, dendritic or polymeric materials can be conjugated, partially conjugated or even not conjugated. Typical representatives of conjugated polymers as can be used in PLEDs or O-SCs are for example poly-para-phenylene vinylene (PPV) systems, which in the broadest sense are based on poly-p-phenylene (PPP), polyfluorene, poly (spiro), poly (indenofluorenes) Polyphenanthrene, polythiophenes, etc., and derivatives of these structures.

The choice of material to produce such organic semiconductor layer is dependent on the intended use of the light-emitting device. This includes that different light-emitting substances which emit light of different colors can be combined in one layer or in different layers. Thus, it is also possible, on use of a plurality of light-emitting materials, for the latter to be arranged in one or more organic light-emitting layers (so-called "multilayers").
In this context, reference is made to WO 2005/109539 A1, where different materials are disclosed for this purpose.
Depending on the application and if a plurality of layers is used the thickness of these organic semiconductor material layers is preferably in the range of 10 - 300 nm, particularly preferably 20 - 150 nm, very particularly preferably in the range of 30 - 100 nm, in particular 40 - 80 nm.

In addition, the OLEDs according to the invention may have further functional layers, which can vary depending on the application. Thus, for example, hole-conductor, electron-conductor, injection and/or barrier layers are conceivable. These may preferably be present, but are not absolutely necessary. If such layers shall be part of the device the skilled person may choose suitable materials which are known for this purpose.

Preparation of the porous layers

There are numerous process variants for the preparation of thin layers or of stacked layers comprising transparent electrically conductive metal oxides, such as chemical vapor deposition, spray pyrolysis, sputtering and sol-gel process.

During formation of the porous metal oxide layer according to the present invention, however, an undesirable change in underlying functional layers should be avoided. The process disclosed here appears to be a suitable method, which is cost-effective and as there are various ways of influencing the properties of the functional coating and makes it possible to provide a precursor composition that can be applied by spin coating, gravure printing, flexographic printing or inkjet printing.

Then after coating solvent evaporates from the wet film. When the temperature is further increased, the conversion takes place into corresponding oxides or mixed oxides and volatile decomposition products are removed. Advantageously the used formulations may be prepared from organometallic compounds with the effect that carbon dioxide, water and other volatile compounds have to be removed when the decomposition is carried out at high temperatures. Another advantage is that the conversion may be carried out by an extremely short-time heating, so that this step does not have great influence on the other underlying layers. This heating may be carried out on a hot plate or for example

in an IR belt furnace. The needed temperatures are in the range of at least 230°C and have to be kept for seconds up to some minutes. In general, a temperature in the range of 300°C up to 450 °C is needed for at least 30 s up to 4 minutes for a complete conversion. In general it is sufficient to keep the needed temperature for less than a minute.

To find out how suitable transparent layers must be built up and which metal oxides are suitable for the described purpose, a series of experiments was performed, inter alia in order to avoid detrimental effects in the overall structure. Primarily the influence of electrical conductivity and the refractive index of the intermediate layer were examined in view of the light outcoupling efficiency of the OLED structure.

These experiments have actually shown that thin interlayers of special mixed metal oxide layers are suitable to improve the light outcoupling in OLEDs.

Oxides and mixed oxides of the metals zinc, gallium, cadmium, indium and tin are known as transparent and conductive and semiconductive materials. In addition to this, in photovoltaic applications indium tin oxide (ITO), indium zinc oxide, aluminum zinc oxide (aluminum-doped zinc oxide), but also titanium-niobium oxide are known in thin transparent layers. For example, in solar cells thin layers of aluminum doped zinc-oxide have been found to be ideally suitable. These layers can be applied by wet chemical methods and the degree of doping by aluminum can be set arbitrarily. Depending on the degree of doping the conductivity and outcoupling is influenced and the effectivity of the cell is influenced. This is why these mixed metal oxides were examined for their applicability as intermediate layers in OLED structures.

The experiments carried out have shown that although all these mixed oxides as mentioned above might be used to solve the problem discussed above, thin indium-zinc-oxide layers (IZO) are ideally suitable as intermediate layers in the examined OLED structures. In particular, special porous indium-zinc-oxide layers have been found suitable.

These experiments verified that the refractive index of the applied intermediate layer should nearly correspond to the mean of the refractive index of neighboring layers, for example of ITO and that of the HTM layer. Advantageously this can be achieved if thin layers of indium zinc oxide, aluminum zinc oxide (aluminum-doped zinc oxide), or titanium-niobium oxide are prepared in printing technologies from precursor compositions and if the precursors are mixed in a suitable ratio. The required ratio of the various oxides in the layer can be calculated and depends on the porosity of the layer and the refractive indexes of the pure oxides which are mixed in the layer. As such, in homogeneous non-porous mixed oxide layers there is a linear relationship between the refractive index of pure oxides and the molar ratio of binary mixed oxides. In layers according to the invention the porosity P is preferably in the range between 60% and 90 %, where the porosity is taken to mean the proportion of the volume that is taken up by cavities (pores). The porosity which is relevant for this application can be determined from the ratio of the refractive indices of the porous layer ($n_S$) and of the non-porous layer ($n_P$). To a good approximation, the following applies to the porosity P (in %):

$$P = 100 \cdot [(n_P - n_S)/(n_P - 1)],$$

as arises due to simple considerations. The refractive index of the respective thin layers can in turn be determined by ellipsometry, by means of a prism coupler or by surface plasmone resonance spectroscopy, as described above.

The average pore size of the layer is preferably in an order of magnitude of 5 to 500 nm, particularly preferably in an order of magnitude of 10 to 200 nm, very particularly preferably in an order of magnitude of 10 to 100 nm, where the pore size must be smaller than the layer thickness of the oxide layer, preferably smaller than half the layer thickness of the oxide layer, particularly preferably smaller than a quarter of the layer thickness of the oxide layer. Preference is given to a narrow pore-size distribution. The pore size and the pore-size distribution can be determined, for example, by scanning electron microscopy and by transmission electron microscopy.

For the production of these porous oxide layers the precursors are mixed together homogeneously with suitable solvents. If necessary, pH regulating compounds and further additives may be added prior to the conversion to mixed oxides. The porous properties of the formed layer arise surprisingly by itself without special measures. But if necessary the pore building can be supported using physical or chemical methods. Thus blowing agents like compressed gases (for example nitrogen), supercritical fluids or low boiling, optionally substituted, hydrocarbons may be introduced into the gel, which do not leave any undesired by-products behind in the oxide layer after conversion. Different blowing agents suitable for this are known to the skilled person.

On evaporation of the blowing agent, the substance supersaturated with gas expands with bubble formation. The evaporation and, where appropriate, cooling increases the viscosity and the porous skeleton solidifies. As blowing agents supercritical fluids may be applied for producing layers having the desired pore size and having closed pores. A preferred supercritical fluid comprises supercritical carbon dioxide. In order to dissolve the material of the organic buffer layer better, further organic compounds or solvents can be added to this medium. This preference can be explained by the relatively easy handling, the good solubility of a large number of organic compounds therein and the inertness during operation of the electronic device.

Chemical blowing agents are solids which decompose at elevated temperature or on exposure to other energy

with liberation of a gas, usually organic oxygen or nitrogen compounds, for example azo compounds, diazo compounds, azido compounds, nitroso compounds or hydrazides (for example J. H. Saunders, R. H. Hansen, in K. C. Frisch, J. H. Saunders (ed.), Plastic foams, Part I, Chap. 2, Marcel Dekker, New York 1972; W. S. Fong, Foamed Plastics, Suppl. A, Process Economics Program Report 97A, SRI Int., Menlo Park, California, Jan. 1984, 29-36).

When a support of pore formation is required, the use of inorganic blowing agents, for example carbonates, is preferred. It is furthermore possible to liberate the blowing agent, for example carbon dioxide in the form of a gas during the gel forming reaction. In particular for pore forming, it may be appropriate to add nucleation seeds. These are finely dispersed solids on which small initial gas bubbles form from the solution supersaturated with gas or supercritical fluid. The porosity and pore size can be controlled through the concentration of the nucleation seeds in the prepared gel comprising the oxide forming precursors. The desired pores are either formed in the viscous gel in form of very small gas bubbles before its application to the surface or during heat treatment.

As already mentioned above, the production of the desired metal oxide layers can be processed from their precursor compounds, which are dissolved in solvents, i.e. metal oxide precursor solutions or metal oxide precursor dispersions can be processed into coating compositions or simply printing inks, which can be used for mass production in conventional coating and printing techniques as mentioned above.

Although many of the known organometallic precursor compounds of the desired metal oxides are suitable for the method according to the invention, preferably metal carboxylates, also called "oximates", are used as organometallic complexes in the present invention [i.e., those organometallic compounds which decompose into volatile components such as carbon dioxide, acetone etc., and the desired metal oxides in the following treatment which is carried out thermally and / or with actinic radiation (UV and / or IR)].

Therefore, in the present invention preferably organometallic compounds are used, which are metal-carboxylate complexes of the metals indium, zinc or tin, aluminum, niobium, titanium, and gallium, optionally in a mixture with metal carboxylate complexes of the metals with coordination numbers 3 to 6. These metal complexes each have at least one ligand from the group of alkoxyimino carboxylic acids (oximates). In connection with the present invention, the term "metals" means the above-mentioned elements, which can comprise either metal or semi-metal, or transition metal properties.

In particular, the at least one ligand is either a 2-(methoxyimino)-alkanoate, 2-(ethoxyimino) alkanoate, or 2-(hydroxyimino)-alkanoate, hereinafter also referred to as oximates. These ligands can be synthesized by the condensation of alpha-keto acids or oxocarboxylic acids with hydroxylamines alkylhydroxylamines or in the presence of bases in an aqueous or methanolic solution.

An enolate is also preferred as ligand, especially acetylacetonate, which is used for other technical purposes and is commercially available in the form of acetylacetonate complexes of various metals.

Preferably, all ligands of the metal-carboxylate complexes are alkoxyimino-carboxylic acid ligands, in particular the previously mentioned.

But also complexes can be used wherein the alkoxyimino carboxylic acid ligands are only additionally complexed with $H_2O$ and no further ligands are present in the metal carboxylate complex, however. Metal acetylacetonates as described above are also complexes which only contain acetylacetonate ligands.

If organometallic oximate precursor compounds of various metals are used as starting materials, it is advantageous if all the starting materials are of the same group of substances, so oximates should be mixed with oximates. The preparation of said metal-carboxylate complexes, which comprise alkoxyimino-carboxylic acid ligands and which are preferably used according to the invention, has already been described in WO 2009/010142 A2 and in WO 2010/078 907 A1 in detail. Therefore, reference is made to these documents in its entirety.

In general, the metal oxide precursors, i.e. the organic gallium, indium, zirkonium, hafnium, zinc, tin, aluminum, titanium or niobium complexes, are formed at room temperature by reaction of an oxo carboxylic acid with at least one hydroxyl or alkyl hydroxylamine in the presence of a base, like tetraethyl ammonium hydrogen carbonate or sodium bicarbonate, and then adding an inorganic gallium, indium, zinc, tin, aluminum, titanium or niobium salt, like e.g. gallium nitrate hexahydrate, anhydrous indium chloride or tin chloride pentahydrate. As oxocarboxylic acids all members of this class of compounds can be used. But oxoacetic acid, or oxopropionic oxobutyric are preferred.

Said organometallic metal oxide precursor compounds (precursors) in the present invention are preferably used in dissolved or dispersed form.

For this purpose, the precursors are dissolved in suitable solvents and their concentrations have to be adapted to the coating process to be used and the number of the applied layers and to the composition of the metal oxide precursor.

Suitable solvents or dispersants are water and/or organic solvents, for example, alcohols, carboxylic acids, esters, ethers, aldehydes, ketones, amines, amides, or aromatics. Also mixtures of organic solvents or dispersants or mixtures of water with organic solvents or dispersants can be used. The selection of solvents or dispersants has to be done in consideration that layers whereon the desired metal oxide layers are to be placed are not adversely affected.

The metal carboxylate complexes with alkoxyimino-carboxylic acid ligands (oximates), which are described before, are preferably dissolved in 2-methoxyethanol.

In a first embodiment of the present invention, an organometallic compound or a mixture of metal-organic compounds in dissolved or dispersed form, that is, a metal oxide precursor solution or dispersion comprising a pore forming agent or small gas bubbles as described above, is applied as a single layer on the respective substrate and is transformed. With this, a porous metal oxide precursor layer is obtained.

The layer is, optionally after drying, thermally converted into a metal oxide layer, or, depending on the composition of the starting materials, converted to a mixed metal oxide layer.

The thermal treatment is carried out at temperatures in the range of at least >200 °C to 500 ° C, preferably in the range of between 250 to 450 °C. The thermal treatment takes place in air or under inert gas. The elevated temperatures have to be kept for seconds up to some minutes, in general at least 30 s up to 4 minutes are needed for a complete conversion. In general it is sufficient to keep the needed temperature for less than a minute.

Now it has surprisingly been found, that the desired light outcoupling characteristics of the resulting transparent mixed oxide layer can be achieved by rapid heating to the desired transition temperature in the range of >200 °C to 500 °C, while the material composition of the precursor layer is maintained.

Light in the visible wavelength range (380 to 780 nm) is almost completely transmitted in layers which have been converted in the temperature range of >200 ° C to 500 ° C in the metal oxide-containing layers, but at least of about 95%. That is, according to the invention produced metal oxide containing layers are optically transparent in the visible region.

Depending on the place where the porous mixed metal oxide layer is inserted in the OLED as an intermediate layer, semiconducting properties are of importance besides of light outcoupling properties. For an increased electrical conductivity of the produced metal oxide layer, the heat treatment can be made in an inert gas atmosphere, preferably under argon gas, although in general it can take place in air.

In another embodiment of the present invention, the application of an organometallic compound and its conversion into a metal oxide or mixed metal oxide can take place for several times in succession, so that a multilayer system of metal oxides, mixed metal oxides, or a combination of both is obtained. In this case, the solutions or dispersions used in each case may contain the organometallic precursor compound at different concentrations depending on the layer.

This means that the total thickness of the mixed oxide layer of the present invention can be achieved by repeatedly applying a precursor layer and repeated conversion by heat treatment. Yet, for a gentle production the desired mixed oxide layer is preferably prepared by only a single application of precursor materials and only one heat treatment to obtain the desired film thickness. For this purpose, it is necessary to adjust the properties of the precursor-containing solution or dispersion so that a single application may be sufficient to obtain the desired layer thickness.

Experiments that were conducted as part of a test matrix unexpectedly showed that porous layers having a relatively high layer thickness could be produced from solutions comprising precursors for the preparation of indium-zinc oxide layers at high concentrations and which could be applied in a single printing step. Advantageously these layers show an increase in the amount of light emitted from this layer, whereas the current density [mA/$cm^2$] remains almost unchanged.

Although it is an option to repeat the application of precursor comprising composition and its conversion into a metal oxide or mixed metal oxide for several times in succession in order to produce a special layer thickness a single application is preferred for reasons of procedural economy. Experiments have shown that these thick layers prepared from compositions comprising precursors at high concentrations show higher efficiencies and an increase of emitted light of at least of +17 %. Thus, for the production of thicker layers starting compositions comprising high concentrations of precursor compounds are preferred. The results of these experiments are shown in Fig. 2.

It is self-explaining that the formulations used for repeated application may comprise the precursor metal complexes in a lower concentration than sols used for a single step process. The precursor concentration may be adjusted in the range of 1 - 20 %. If the precursor composition is applied for several times the concentration should be in the range of 10 - 15 % by weight. For a single application the precursor concentration preferably should be higher than 5 % by weight, most preferably in the range of 9 - 15% by weight.

Although the previously applied film, mainly consisting of the precursor compounds used, is homogeneous and uniform, a more or less porous film of mixed metal oxides can surprisingly be obtained from the precursor film by heating. This porous film especially results if the temperature is raised in a very short time to the conversion temperature.

But the preparation of the porous mixed metal oxide layer is not only influenced by the controlled temperature treatment annealing temperature, ramp, hotplate, UV etc.) but also by the used oximate precursors in solution, and by change of metal combination, selected from the group indium, tin, zinc, aluminum, titanium, and niobium comprising compounds in the liquid formulation, by the applied concentrations of metal precursors, and by application technique, like spin-coating, ink jet printing, gravure printing or flexo printing, followed by the annealing step.

The close examination of the formed mixed metal oxide films shows that the layers are porous whereas the surfaces are smooth. Closer investigations of prepared 20 - 40 nm thick films showed, that they form a highly porous layer. This is particularly surprising since usually functional mixed oxide films, for example ITO films used as anode, have smooth, partly reflecting surfaces.

Although one might assume that the porosity would lead to a reduction in the light transmission and the light outcoupling in the visible range, it was found that this thin, transparent, porous mixed oxide layers in an OLED can lead to an improvement in the light output of up to 20%.

This improvement in efficiency can be achieved in particular if a transparent indium-zinc oxide layer (IZO) having a suitable thickness is inserted as an intermediate layer between the ITO anode and the hole transport layer (HTL) and optionally between the ITO anode and glass substrate layer.

For example, in order to increase the output of light from an OLED layer structure a layer of porous indium-zinc oxide having a thickness in the range of 10 - 30 nm is applied on top of a structured ITO substrate, which in turn is suitable for the manufacturing of an OLED. This extra layer does not influence negatively any device performance. In addition to this, the introduction of this porous indium-zinc oxide layer has no other disadvantageous effects on the process steps which usually follow.

The improvement seems to be due to the fact that the inserted porous mixed oxide is particularly intense connected to the respective adjacent layer and the porosity favors the light emission and light transfer to the adjacent layer and at the same time the porosity seems to prevent reflections.

Thus, by the present invention, the intermediate layers may be incorporated into the layer structure of OLED structures in a simple wet-chemical process, under environmental atmosphere conditions which greatly enhance the internal light extraction. This method is suitable for the production on an industrial scale.

By varying the application method, the used metal oxide precursor compositions and its concentration the layer structure and the layer thicknesses can be tailored to different needs. By changing the temperature control for the conversion of the precursors to the desired mixed metal oxides, as well as of the precursor compositions used an adaption to the requirements of the treated devices is possible. By adjusting the gas atmosphere during the conversion by heat treatment, it is also possible to influence the properties of the semiconducting layers.

The process of the present invention makes it possible to improve the internal light extraction from OLEDs significantly in a simple, cost-effective manner by introducing intermediate layers as thin porous, transparent mixed metal oxide layers.

In general, for the production of the devices, a process may be used, as described, for example, in US 2007/0034862A1, which should be correspondingly adapted for the individual case without further inventive step. The way in which suitable layers of low refractive index or suitable transparent porous oxide interlayers can be produced has been described in detail above.

Surprisingly, the electronic device structure according to the present invention, in which at least one transparent porous layer consisting of mixed oxides of low refractive index is used, offers the following advantages:

1) The output of light from the electronic device is further improved significantly.
2) As a consequence, the observed efficiency of the organic electronic device, in particular also the power efficiency is increased in a range as described above. This is of vital importance for practical use, in particular for mobile applications.
3) Due to the increased efficiency, the lifetime of the organic electronic device is also increased since this is always dependent on the brightness and current density with which the device is operated, and, due to the higher output efficiency, an organic light-emitting diode can be operated with lower current density for the same observed brightness.
4) The novel structure of the organic electronic device can be achieved without difficulty. In particular, considerable technical complexity is not necessary, in contrast to structures in accordance with the prior art.
5) In solar cells and detectors, the sensitivity on use in diffuse light is improved.
6) The novel structure can be combined without difficulties with the materials usually used and the layer structure usually used. It is thus possible to integrate the transparent porous oxide layer according to the invention into the device without significant changes in the structure, but with an improved internal light outcoupling.

**List of Figures:**

Fig. 1: Scheme of internal and external outcoupling of a standard bottom emission OLED

Fig. 2: Impact of layer thickness and concentration of precursor formulation on EQE (external quantum efficiency)

Fig. 3: Light generation within an OLED

## Examples

Even without any further explanations, it is assumed that a person skilled in the art can make use of the above description in its widest scope. The preferred embodiments and examples are therefore to be regarded merely as descriptive but in no way limiting disclosures.

For better understanding and for illustration, examples are given below which are within the scope of protection of the present invention. These examples also serve for the illustration of possible variants.

The complete disclosure of all applications, patents and publications mentioned above and below are incorporated by reference in the present application and shall serve in cases of doubt for clarification.

It goes without saying that, both in the examples given and also in the remainder of the description, the quoted percentage data of the components present in the compositions always add up to a total of 100% and not more. Given temperatures are measured in °C.

## Production of OLEDs

The production of OLEDs according to the invention and of prior art OLEDs is exemplary processed according to a publicly known process as disclosed in WO 04/058911 and which is adapted to conditions given here (layer thickness variation, materials).

With the following examples according to the invention and with reference examples data of various OLEDs are presented.

As substrates glass slides are used, which are coated with a layer of structured ITO (indium tin oxide) having a thickness of 50 nm.

The key layer according to this invention, which is installed, between the ITO anode structure and the rest of the OLED device is processed as follows:

For example a 10% solution comprising indium and zinc oximate in a ratio of 3:2 solved in 2-methoxyethanol is applied by spin coating (2500rpm,. 30sec) over the entire surface and then annealed at 350 ° C for 5min.

If the additional layer is composed of several layers, the process has to be repeated several times. In the following the identical layer sequence is applied as in the reference OLED.

The OLEDs basically have the following layer structure:

substrate HTM1:F4TCNQ(3%) (20 nm) / HTM1 (155 nm) / HTM1:F4TCNQ(3%) (20 nm) / HTM1 (20 nm) / H1:SEB1(5%) (20 nm) / ETM1:LiQ(50%)(30 nm) / LiQ (1 nm) and finally a cathode. The cathode is formed by a 100 nm thick aluminium oxide layer.

The materials needed for the production of the OLEDs are listed in Table 1:

| Table 1: Chemical structures of used OLED-materials | | |
|---|---|---|
| 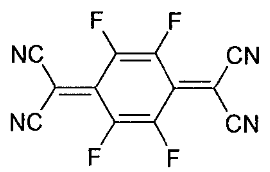 | 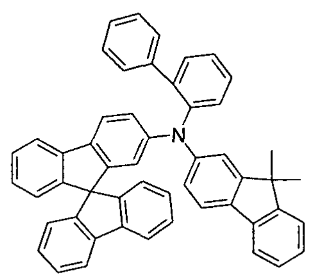 | 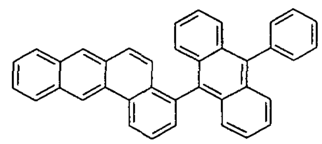 |
| F4TCNQ | HTM1 | H1 |

(continued)

| Table 1: Chemical structures of used OLED-materials | | |
|---|---|---|
| 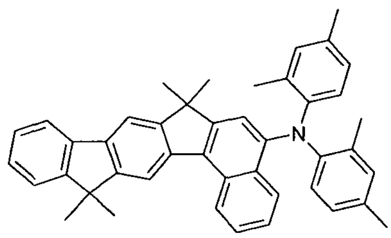 | 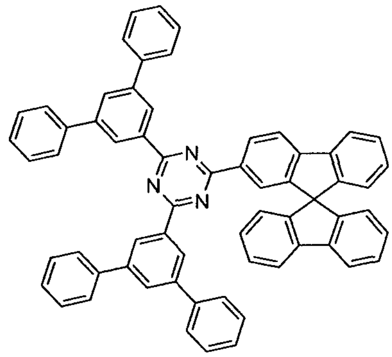 | 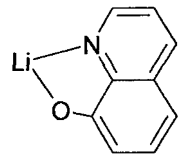 |
| SEB1 | ETM1 | LiQ |

All materials are thermally evaporated in a vacuum chamber. The emission layer is always composed of at least a matrix material (host material) and an emitting dopant (dopant, emitter), which is added to the matrix material(s) by co-evaporation in a specific volume fraction.

A reference such as H1: SEB (5%) in this case means that the material H1 is present in a volume fraction of 95% and SEB in a proportion of 5% in the layer. Analogously, the electron transporting layer or the hole injection layers may be composed of a mixture of two materials.

A reference such as H2: H3 (60%): TEG (10%) in this case means that the material H2 is present in a volume fraction of 30%, H3 is present in a volume fraction of 60% and TEG in a proportion of 10% in the layer.

The OLEDs are characterized by the following parameters:
the external quantum efficiency (EQE, measured as a percentage) as a function of the luminance is calculated from the current-voltage-luminance characteristics (IUL characteristic lines) determined by assuming a lambertian radiation pattern, and the life period.

**Example1**

It has been shown that the EQE increases significantly if the layer thickness of porous metal oxide increases. The same can be proven if the number of layers of porous metal oxide increases compared to an OLED without this layer. In case of blue emission an increase of more than 15 % is proven. It could also be shown that an increase in the EQE is present in red-and green-emitting OLEDs, without the service life is impaired. Accordingly, the increase in efficiency is not limited to a specific wavelength range.

| **Formulation / single outcoupling layer** | **EQE [%] @ 1000 cd/m$^2$** |
|---|---|
| **Standard** | **6,9** |
| **5%wt** | **7,2** |
| **10%wt** | **7,7** |
| **15%wt** | **8,2** |

| **Formulation / single outcoupling layer** | **EQE [%] @ 1000 cd/m$^2$** |
|---|---|
| **Standard** | **6,9** |
| **5%wt** | **7,2** |
| **10%wt** | **7,7** |
| **15%wt** | **8,2** |
| *wt% is the content of the solid (concentration) of spincoat formulation and this is related to layer thickness | |

## Claims

1. OLED device with improved internal light outcoupling, having an ITO electrode and a hole transport layer, comprising at least one additional thin, porous and transparent metal oxide layer, **characterized in that** the porous metal oxide layer is inserted as additional intermediate layer between the ITO electrode and the hole transport layer.

2. OLED device according to claim 1, comprising at least one additional thin, porous and transparent mixed metal oxide layer comprising mixed oxides of at least two metals selected from the group of indium, zinc, tin, aluminum, gallium, cadmium, titanium and niobium.

3. OLED device according to claim 2, comprising at least one additional thin porous and transparent mixed metal oxide layer containing indium zinc oxide.

4. OLED device according to one or more of the claims 1 to 3, comprising at least one additional thin porous and transparent mixed metal oxide layer having a thickness in the range of 10 - 200 nm, preferably in the range of 15 - 50 nm.

5. OLED device according to any one of the claims 1 to 3, comprising at least one additional thin porous and transparent mixed metal oxide layer having a thickness in the range of 20 - 40 nm.

6. Process for manufacturing an OLED device according to any one of the claims 1 - 5 with improved internal light outcoupling **characterized in that** at least one additional thin porous and transparent intermediate layer is inserted into the layered structure by the steps of

   a) applying a precursor composition comprising at least two metal oxide precursors and optionally a suitable porogen or blowing agent, which is applied to a respective intermediate layer
   b) drying the applied precursor composition layer
   and
   c) converting the dried layer into the corresponding thin porous and transparent mixed metal oxide layer by rapid heating to conversion temperature, which is between >150°C to 500°C, and keeping the temperature is carried out for at least 30 seconds up to 4 minutes.

7. Process according to claim 6, **characterized in that** the porous intermediate layer is inserted by applying and conversion of a single precursor composition layer.

8. Process according to claim 6 or 7, **characterized in that** the porous intermediate layer is inserted by applying and conversion precursor composition layers repeatedly.

9. Process according to one of the claims 6, 7 or 8, **characterized in that** the intermediate layer is produced by applying a composition having a metal oxide precursor concentration in the range of 1 - 20 % by weight.

10. Process according to one of the claims 6, 7 or 8, **characterized in that** the intermediate layer is produced by applying a composition having a metal oxide precursor concentration in the range of 9 - 15% by weight.

11. Process according to one or more of the claims 6 to 10, **characterized in that** the conversion into mixed oxide is carried out by rapid heating to temperatures in the range of 300 - 450 °C.

12. Process according to one or more of the claims 6 or 11, **characterized in that** the conversion is carried out by rapid heating on a hot plate or on a IR belt furnace.

## Patentansprüche

1. OLED-Vorrichtung mit verbesserter interner Lichtauskopplung, mit einer ITO-Elektrode und einer Lochtransportschicht, enthaltend mindestens eine zusätzliche dünne, poröse und transparente Metalloxidschicht, **dadurch gekennzeichnet, dass** die poröse Metalloxidschicht als zusätzliche Zwischenschicht zwischen der ITO-Elektrode und der Lochtransportschicht eingefügt wird.

2. OLED-Vorrichtung nach Anspruch 1, enthaltend mindestens eine zusätzliche dünne, poröse und transparente Metallmischoxidschicht enthaltend Mischoxide von mindestens zwei Metallen, die aus der Gruppe Indium, Zink, Zinn, Aluminium, Gallium, Cadmium, Titan und Niob ausgewählt sind.

3. OLED-Vorrichtung nach Anspruch 2, enthaltend mindestens eine zusätzliche dünne poröse und transparente Metallmischoxidschicht, die Indium-Zink-Oxid enthält.

4. OLED-Vorrichtung nach einem oder mehreren der Ansprüche 1 bis 3, enthaltend mindestens eine zusätzliche dünne poröse und transparente Metallmischoxidschicht mit einer Dicke im Bereich von 10 - 200 nm, vorzugsweise im Bereich von 15 - 50 nm.

5. OLED-Vorrichtung nach einem beliebigen der Ansprüche 1 bis 3, enthaltend mindestens eine zusätzliche dünne poröse und transparente Metallmischoxidschicht mit einer Dicke im Bereich von 20 - 40 nm.

6. Verfahren zur Herstellung einer OLED-Vorrichtung nach einem beliebigen der Ansprüche 1 - 5 mit verbesserter interner Lichtauskopplung, **dadurch gekennzeichnet, dass** man mindestens eine zusätzliche dünne poröse und transparente Zwischenschicht durch die Schritte

   a) Aufbringen einer Vorläuferzusammensetzung enthaltend mindestens zwei Metalloxidvorläufer und gegebenenfalls ein geeignetes Porogen oder Treibmittel, die auf eine jeweilige Zwischenschicht aufgebracht wird
   b) Trocknen der aufgebrachten Schicht der Vorläuferzusammensetzung und
   c) Umwandeln der getrockneten Schicht in die entsprechende dünne poröse und transparente Metallmischoxidschicht durch rasches Erhitzen auf die Umwandlungstemperatur, die zwischen >150° und 500°C liegt, und Halten der Temperatur für mindestens 30 Sekunden bis 4 Minuten durchgeführt wird,
   in die Schichtstruktur einfügt.

7. Verfahren nach Anspruch 6, **dadurch gekennzeichnet, dass** die poröse Zwischenschicht durch Aufbringen und Umwandlung einer einzigen Schicht der Vorläuferzusammensetzung eingefügt wird.

8. Verfahren nach Anspruch 6 oder 7, **dadurch gekennzeichnet, dass** die poröse Zwischenschicht durch wiederholtes Aufbringen und Umwandlung von Schichten der Vorläuferzusammensetzung eingefügt wird.

9. Verfahren nach einem der Ansprüche 6, 7 oder 8, **dadurch gekennzeichnet, dass** die Zwischenschicht durch Aufbringen einer Zusammensetzung mit einer Konzentration an Metalloxidvorläufer im Bereich von 1 - 20 Gew.-% hergestellt wird.

10. Verfahren nach einem der Ansprüche 6, 7 oder 8, **dadurch gekennzeichnet, dass** die Zwischenschicht durch Aufbringen einer Zusammensetzung mit einer Konzentration an Metalloxidvorläufer im Bereich von 9 - 15 Gew.-% hergestellt wird.

11. Verfahren nach einem oder mehreren der Ansprüche 6 bis 10, **dadurch gekennzeichnet, dass** die Umwandlung in das Mischoxid durch rasches Erhitzen auf Temperaturen im Bereich von 300 - 450 °C durchgeführt wird.

12. Verfahren nach einem oder mehreren der Ansprüche 6 bis 11, **dadurch gekennzeichnet, dass** die Umwandlung durch rasches Erhitzen auf einer Heizplatte oder auf einem IR-Gürtelofen durchgeführt wird.

## Revendications

1. Dispositif OLED présentant un couplage en sortie de la lumière interne amélioré, comportant une électrode en ITO et une couche de transport de trous, comprenant au moins une couche en oxyde(s) métallique(s) mince, poreuse et transparente additionnelle, **caractérisé en ce que** la couche en oxyde(s) métallique(s) poreuse est insérée en tant que couche intermédiaire additionnelle entre l'électrode en ITO et la couche de transport de trous

2. Dispositif OLED selon la revendication 1, comprenant au moins une couche en oxydes métalliques mélangés mince, poreuse et transparente additionnelle qui comprend des oxydes mélangés d'au moins deux métaux qui sont sélectionnés parmi le groupe qui est constitué par l'indium, le zinc, l'étain, l'aluminium, le gallium, le cadmium, le titane et le niobium.

**3.** Dispositif OLED selon la revendication 2, comprenant au moins une couche en oxydes métalliques mélangés mince, poreuse et transparente additionnelle qui contient de l'oxyde d'indium et de zinc

**4.** Dispositif OLED selon une ou plusieurs des revendications 1 à 3, comprenant au moins une couche en oxydes métalliques mélangés mince, poreuse et transparente additionnelle qui présente une épaisseur qui s'inscrit à l'intérieur de la plage de 10 nm - 200 nm, de préférence à l'intérieur de la plage de 15 nm - 50 nm.

**5.** Dispositif OLED selon une ou plusieurs des revendications 1 à 3, comprenant au moins une couche en oxydes métalliques mélangés mince, poreuse et transparente additionnelle qui présente une épaisseur qui s'inscrit à l'intérieur de la plage de 20 nm - 40 nm.

**6.** Procédé pour fabriquer un dispositif OLED selon l'une quelconque des revendications 1 - 5 présentant un couplage en sortie de la lumière interne amélioré, **caractérisé en ce qu'**au moins une couche intermédiaire mince, poreuse et transparente additionnelle est insérée à l'intérieur de la structure en couches au moyen des étapes constituées par :

a) l'application d'une couche de composition de précurseurs qui comprend au moins deux précurseurs d'oxyde(s) métallique(s) et en option, un agent porogène ou d'expansion par gonflement approprié, laquelle couche de composition est appliquée sur une couche intermédiaire respective ;
b) le séchage de la couche de composition de précurseurs appliquée ; et
c) la conversion de la couche séchée selon la couche en oxydes métalliques mélangés mince, poreuse et transparente correspondante au moyen d'un chauffage rapide jusqu'à la température de conversion, laquelle est > 150 °C et va jusqu'à 500 °C, et le mai ntien de la température est mis en oeuvre pendant au moins 30 secondes jusqu'à 4 minutes.

**7.** Procédé selon la revendication 6, **caractérisé en ce que** la couche intermédiaire poreuse est insérée par application et conversion d'une unique couche de composition de précurseurs.

**8.** Procédé selon la revendication 6 ou 7, **caractérisé en ce que** la couche intermédiaire poreuse est insérée par application et conversion de couches de composition de précurseurs de façon répétée.

**9.** Procédé selon l'une des revendications 6, 7 ou 8, **caractérisé en ce que** la couche intermédiaire est produite en appliquant une composition qui présente une concentration en précurseur(s) d'oxyde(s) métallique(s) qui s'inscrit à l'intérieur de la plage de 1 % - 20 % en poids.

**10.** Procédé selon l'une des revendications 6, 7 ou 8, **caractérisé en ce que** la couche intermédiaire est produite en appliquant une composition qui présente une concentration en précurseur(s) d'oxyde(s) métallique(s) qui s'inscrit à l'intérieur de la plage de 9 % - 15% en poids.

**11.** Procédé selon une ou plusieurs des revendications 6 à 10, **caractérisé en ce que** la conversion selon un oxyde mélangé est mise en oeuvre au moyen d'un chauffage rapide jusqu'à des températures qui s'inscrivent à l'intérieur de la plage de 300 °C - 450 °C.

**12.** Procédé selon une ou plusieurs des revendications 6 ou 11, **caractérisé en ce que** la conversion est mise en oeuvre au moyen d'un chauffage rapide sur une plaque chaude ou sur un four à bande(s) de transport IR.

Fig. 1

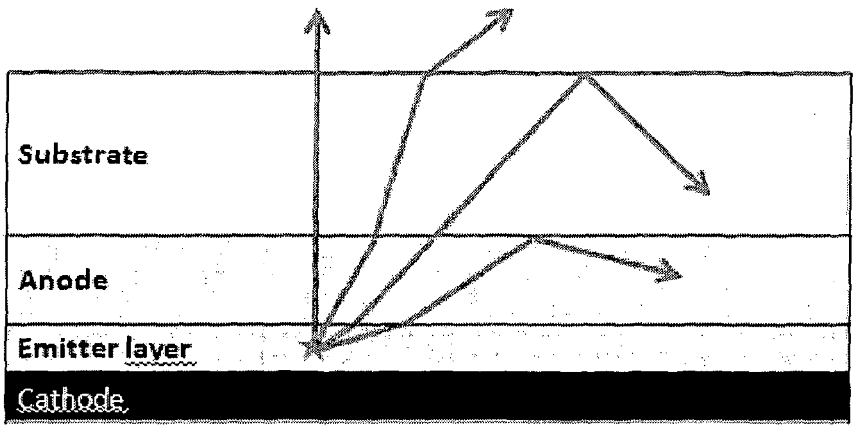


Fig. 2

**Improved OLED performance by increased thickness of a single layer**

| Formulation / single outcoupling layer | EQE [%] @ 1000 cd/m² |
|---|---|
| Standard | 6,9 |
| 5%wt | 7,2 |
| 10%wt | 7,7 |
| 15%wt | 8,2 |

**OLED efficiency depending on number of layers**

| Formulation / single & multi-outcoupling layer | EQE [%] @ 1000 cd/m² |
|---|---|
| Standard | 6,9 |
| 5%wt 1 layer | 7,2 |
| 5%wt 3 layers | 7,5 |
| 10%wt 1 layer | 7,7 |
| 10%wt 4 layers | 7,9 |

Fig. 3

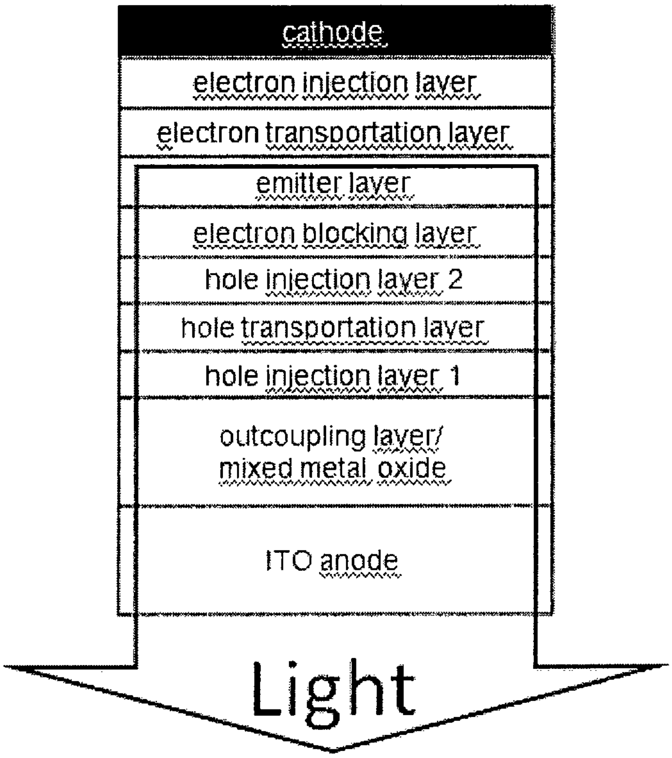
cathode
electron injection layer
electron transportation layer
emitter layer
electron blocking layer
hole injection layer 2
hole transportation layer
hole injection layer 1
outcoupling layer/
mixed metal oxide
ITO anode
Light

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2007076913 A1
- WO 2012141875 A
- US 2011094577 A
- WO 2005109539 A1
- WO 2009010142 A2
- WO 2010078907 A1
- US 20070034862 A1
- WO 04058911 A


### Non-patent literature cited in the description


- **REINEKE, S. ; LINDNER, F. ; SCHWARTZ, G. ; SEIDLER, N. ; WALZER, K. ; LÜSSEM, B. ; LEO, K.** *Nature,* 2009, vol. 459, 234-238
- Organic Light Emitting Materials and Devices XIII. **NOWY, S. ; FRISCHEISEN, J. ; BRÜTTING, W.** Proc. of SPIE. vol. 7415, 7415C1-8
- Simulation based optimization of light-outcoupling in organic light-emitting diodes'', In: Organic Light Emitting Materials and Devices XIII. **NOWY, S. ; FRISCHEISEN, J. ; BRÜTTING, W.** Proc. of SPIE. 2009, vol. 7415, 7415C1-8
- **LEE, Y. ; SE-HEON KIM, S. ; GUK-HYUN KIM, G. ; LEE, Y.** *OPTICS EXPRESS,* 2005, vol. 13 (15), 5864-5870
- **KOO et al.** *Nature Photonics,* 2010, vol. 4, 222-226
- **CHANG et al.** *Journal of Appl. Phys.,* 2013, vol. 113, 204502
- **R. M. A. AZZAM ; N. M. BASHARA.** Ellipsometry and Polarised Light. North Holland Physics, 1987
- **LO, S.-C. ; BURN, P. L.** *Chem. Rev.,* 2007, vol. 107, 1097
- **WILLIAMS, J. A. G. ; DEVELARY, S. ; ROCHESTER, D. L. ; MURPHY, L.** *Coordin. Chem. Rev.,* 2008, vol. 252, 2596
- Plastic foams. Marcel Dekker, 1972
- **W. S. FONG.** Foamed Plastics, Suppl. A. *Process Economics Program Report 97A, SRI Int.,* January 1984, 29-36